# EUROPÄISCHE PATENTSCHRIFT

(11) **EP 2 217 937 B1**
(45) Veröffentlichungstag und Bekanntmachung des Hinweises auf die Patenterteilung: **25.04.2012**
(21) Anmeldenummer: 08857759.8
(22) Anmeldetag: 03.12.2008
(51) Int. Cl.: G01R 31/12, H02M 1/12, G01R 31/14

(54) **VORRICHTUNG ZUR HOCHSPANNUNGSPRÜFUNG VON TRANSFORMATOREN**
DEVICE FOR HIGH VOLTAGE TESTING OF TRANSFORMERS
DISPOSITIF D'ESSAI À HAUTE TENSION DE TRANSFORMATEURS

(30) Priorität: 08.12.2007 DE 102007059289
(43) Veröffentlichungstag der Anmeldung: 18.08.2010
(73) Patentinhaber: Maschinenfabrik Reinhausen GmbH, 93059 Regensburg (DE)
(72) Erfinder: THIEDE, Andreas, 01465 Schönborn (DE); HUANG, Yulong, 01069 Dresden (DE); STEPHAN, Uwe, 01705 Freital (DE)
(74) Vertreter: Meier, Gerald Heinz
(86) Internationale Anmeldenummer: PCT/EP2008/010207
(87) Internationale Veröffentlichungsnummer: WO 2009/071266

(56) Entgegenhaltungen:
- EP-A- 0 268 046
- EP-A- 1 017 147
- EP-A- 1 318 594
- DE-C1- 19 546 420
- WINTER A ET AL: "A mobile transformer test system based on a stativ frequency converter" XV INTERNATIONAL SYMPOSIUM ON HIGH VOLTAGE ENGINEERING, UNIVERSITY OF LJUBLJANA, ELEKTROINSITUT MILAN VIDMAR, LJUBLANA, SLOVENIA, AUGUST 27-31, 2007,, [Online] 4. September 2007 (2007-09-04), Seiten 1-6, XP002500564 Gefunden im Internet: URL:http://www.ish2007.org/pdf/aWinter.pdf > [gefunden am 2008-10-20]

## Beschreibung

Die vorliegende Erfindung betrifft eine Vorrichtung zur Prüfung von Transformatoren. Im Besonderen betrifft die Erfindung eine Vorrichtung zur Prüfung von Transformatoren, wobei die Vorrichtung einen statistischen Frequenzumrichter umfasst, der mehrere Ausgänge besitzt, die mit einer Filtereinrichtung verbunden sind. Die Filtereinrichtung besitzt ebenfalls mehrere Ausgänge, die mit einem Anpasstransformator verbunden sind, wobei der Anpasstransformator mit dem jeweils für die Prüfung vorgesehenen Transformator verbunden ist.

Ferner betrifft die Erfindung die Verwendung der erfindungsgemäßen Vorrichtung bei der Hochspannungsprüftechnik.

Ein Artikel mit dem Titel "High Performance Digital Control of Uninterruptible Power Supply (UPS) Using an Applications Specific Integrated Circlet (ASIC)" wurde in dem Konferenzband der Konferenz "European Conference on Power Electronics and Applications" veröffentlicht. Die Konferenz fand in Florenz vom 03.September 1991 bis 06.September1991 statt. Die Veröffentlichung des Konferenzbandes erfolgte ebenfalls 1991. Zur vollständigen digitalen Kontrolle eines UPS-Systems wurde ein ASIC entsprechend entworfen, um eine schnelle Strom- und Spannungskontrolle zu ermöglichen. Durch die Verwendung dieses ASIC's ist es mit dem UPS-System möglich, ein exzellentes dynamisches Verhalten zu erzielen (schnelle Sprungantwort, geringe harmonische Störung bei nicht linearen Belastungen). Die digitale Schaltung umfasst sieben PI-Controler, den Sinusgenerator, das Interface zu den Analog-Digitalwandlem und die PWM-Erzeugung für die Schaltsignale. Eine unterbrechungsfreie Stromversorgung (UPS) ist für alle Anwendungen notwendig, bei denen ein elektrisches System auch in dem Fall eines Stromausfalls arbeiten muss.

Die Deutsche Offenlegungsschrift DE 19 239 85 offenbart einen Filter für ein Leistungsübertragungssystem. In Wechselstromsystemen ist es oftmals erforderlich, unerwünschte harmonische Schwingungen auszufiltern. Das mehrphasige elektrische Leistungsübertragungssystem besteht aus mehreren Leitungen, die eine gewisse Induktivität besitzen. Die Leitungen werden mit Wechselstrom beaufschlagt, der sowohl charakteristische, als auch nicht charakteristische harmonische Komponenten besitzt. Ebenso sind mehrere Filter für die charakteristischen harmonischen Komponenten mit den Leitungen gekoppelt. Ebenso ist ein weiterer Filter vorhanden, der eine Impedanz enthält, die mit den Leitungen gekoppelt ist und die dazu dient die nicht charakteristische harmonische Komponente der Systemspannung zu dämpfen. Diese charakteristische harmonische Komponente entsteht durch die Wechselwirkung der nichtcharakteristischen harmonischen Komponente des Stroms mit einer großen Impedanz, die sich ergibt, wenn die Induktivität und die Impedanz des harmonischen Filters in Resonanz sind. Das Dokument erwähnt jedoch nichts von der Prüfung von Transformatoren.

Die Deutsche Patentschrift DE 42 323 56 offenbart eine Stromversorgungseinrichtung mit mindestens zwei Stromquellen. Jede Stromquelle wird über mindestens einen zugeordneten Stromrichter in ein Wechselstromnetz eingespeist. Zur Herabsetzung der Amplitude einer bestimmten vorhandenen Oberschwingung ist die Spannung von mindestens einem der Stromrichter mit Hilfe eines Steuerwinkels phasenverschoben zu mindestens einem anderen Stromrichter in das Netz eingespeist.

Die Deutsche Patentschrift DE 19 546 420 offenbart ebenfalls eine unterbrechungsfreie Stromversorgungseinrichtung. Die unterbrechungsfreie Stromversorgungseinrichtung umfasst eine Netzkomutierungsdrossel, einen Spannungszwischenkreis-Umrichter mit zugehöriger Steuereinrichtung, einen Ausgangsfilter, bestehend aus einem Transformator mit großer Streuinduktivität und Filterkondensatoren zur Netzrückschalteeinrichtung mit zugehöriger Steuereinrichtung und einem Handumgehungsschalter. Als Umrichter wird ein Frequenzumrichter der Antriebstechnik verwendet. Diesem Frequenzumrichter ist ein Eingangsfilter vorgeschaltet, wobei an den Gleichspannungsanschlüssen eine Batterieankoppelvorrichtung vorgesehen ist. Somit kann man mit handelsüblichen Bauelementen der Antriebstechnik und mit USV-spezifischen Bauelementen eine unterbrechungsfreie Stromversorgung aufbauen, die die technischen und wirtschaftlichen Synergien der Antriebstechnik nutzt. Das Dokument befasst sich ebenfalls nicht mit der Prüfung von Transformatoren.

Die EP 0 268 046 A2 beschreibt ein Verfahren und eine Schaltungsanordnung zum Regeln und Steuern von Dreiphasenwechselrichtern mit Folgeregelung. Schwerpunkt dieser Anmeldung liegt in der Beschreibung der Folgeregelung des Wechselrichters, die sich vorteilhaft bei einer asymmetrischen Belastung der Anlage auswirkt. Die Verwendung eines Transformators zwischen Wechselrichter und Filtereinheit ist als Applikationsbeispiel angeführt. Er dient lediglich zur Spannungstransformation.

Die DE 26 08 541 A1 beschreibt ein elektromagnetisch geschirmtes Versorgungsgerät, bei dem zur Unterdrückung asymmetrischer Störgrößen neben dem elektrostatischen Schirm auf der Sekundärseite des Transformators ein elektrisches Aufhebungssignal gewonnen und gegenphasig in den Nutzsignalstrompfad eingespeist wird.

Eine Vorrichtung zur Hochspannungsprüfung von Transformatoren, mit einem mehrere Ausgänge aufweisenden statischen Frequenzumrichter, ist aus der Veröffentlichung Winter A. et al: "A Mobile Transformer Test System Based on a Static Frequency Converter", XV International Symposium on High Voltage Engineering, University of Ljubliana, 27- 31 August 2007, bekannt geworden.

Aufgabe der Erfindung ist, eine Vorrichtung zur Prüfung von Transformatoren zu schaffen, die eine Verbesserung hinsichtlich der Unterdrückung asymmetrischer Störungen zeigt.

Die obige Aufgabe wird gelöst durch eine Vorrichtung, die die Merkmale des Anspruchs 1 umfasst.

Bei der Erfindung ist die Vorrichtung zur Prüfung von Transformatoren mit einem statischen Frequenzumrichter versehen. Der Frequenzumrichter besitzt mehrere Ausgänge, die mit einer Filtereinrichtung verbunden sind, die ebenfalls mehrere Ausgänge umfasst, die wiederum mit einem Anpasstransformator verbunden sind. Der Anpasstransformator selbst ist mit dem jeweils für die Prüfung vorgesehenen Transformator verbunden. Die Filtereinrichtung ist ein Filtertransformator.

Zwischen der Primärseite und der Sekundärseite des Filtertransformators ist ein elektrostatischer Schirm vorgesehen. Ebenso sind auf der Sekundärseite des Filtertransformators mehrere Filterkondensatoren vorgesehen. Die Filterkondensatoren sind dabei in einer Sternschaltung angeordnet.

Es ist von besonderem Vorteil, wenn der statische Frequenzumrichter und der Filtertransformator zusammen mit den Filterkondensatoren in einem Schaltschrank untergebracht sind. Somit wird erreicht, dass die Weiterleitung von asymmetrischen Störungen zu dem der Prüfung unterzogenen Transformator unterdrückt wird.

Im Folgenden sollen Ausführungsbeispiele die Erfindung und ihre Vorteile anhand der beigefügten Figuren näher erläutern.
- Figur 1: zeigt einen Frequenzumrichter, der bei der Trafo-Prüfung zum Einsatz kommt. Der Frequenzumrichter ist dabei ein statischer Frequenzumrichter mit L-C-Sinusfilter.
- Figur 2: zeigt eine schematische Darstellung der Außenleiterspannung des Frequenzumrichters, die nach dem Sinusfilter anliegt.
- Figur 3: zeigt eine Darstellung der pulsfrequenten Sprünge der Leiter-Erde-Spannung am Wechselrichterausgang.
- Figur 4: zeigt die erfindungsgemäße Vorrichtung, bei der ein statischer Frequenzumrichter mit einem Filtertransformator verwendet wird.

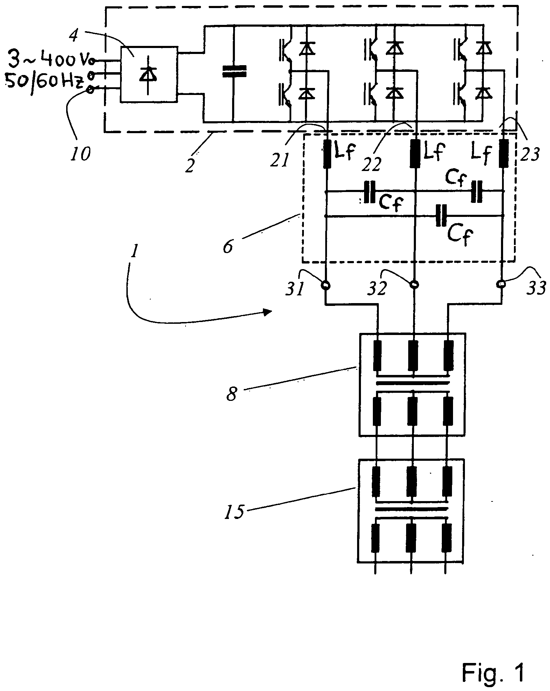

Figur 1 zeigt eine Vorrichtung des Standes der Technik, die zur Prüfung von Leistungstransformatoren der Energietechnik Verwendung findet. Bisher erfolgte die Prüfung mit rotierenden Umformern (Motor-Generator-Sätzen). Diese rotierenden Umformer sind wie in Figur 1 dargestellt, durch einen statischen Frequenzumrichter 2 ersetzt. Die statischen Frequenzumrichter 2 besitzen klare Vorteile gegenüber den rotierenden Umformern in Bezug auf Dynamik, Verschleiß, Gewicht und Verfügbarkeit. Der statische Frequenzumrichter 2 wird mit einer Wechselspannung 10 versorgt. Die Wechselspannung 10 gelangt zunächst auf einen Gleichrichter. Der Frequenzumrichter 2 weist einen ersten Ausgang 21, einen zweiten Ausgang 22 und einen dritten Ausgang 23 auf. Der statische Frequenzumrichter ist ein Spannungszwischenkreis- Umrichter mit einer digitalen Steuerung und Regelung

Der Frequenzumrichter 2 stellt dabei die notwendige variable Ausgangsspannung, sowie die verschiedenen benötigten Prüffrequenzen zur Verfügung. Die Prüffrequenzen bzw. die Prüfspannung muss dabei bestimmten Anforderungen genügen. Die Frequenzumrichter 2 müssen dabei eine sinusförmige, symmetrische Wechselspannung erzeugen, die einen Klirrfaktor von kleiner als 5 % aufweist. Zur Überprüfung der Isolationssysteme der Leistungstransformatoren dient die induzierte Spannungsprüfung, bei der Teilentladungsmessungen durchgeführt werden. Die auf diese Messung einwirkenden äußeren Störungen sollen einen TE-Grundstörpegel von Qₛ=100pC nicht überschreiten. Dies schließt Störungen mit ein, die durch die Prüfspannungsquelle selbst verursacht werden.

Der erste Ausgang 21, der zweite Ausgang 22 und der dritte Ausgang 23 des statischen Frequenzumrichters 2 wird einem Sinusfilter 6 zugeführt. Der Sinusfilter 6 wirkt als Tiefpassfilter, welcher als L-C-Filter realisiert ist. Der Sinusfilter 6 weist einen ersten Ausgang 31, einen zweiten Ausgang 32 und einen dritten Ausgang 33 auf. Der erste Ausgang 31, der zweite Ausgang 32 und der dritte Ausgang 33 des Sinusfilters 6 sind mit einem Anpasstransformator 8 verbunden. Der Anpasstransformator 8 ist selbst wiederum mit einem Transformator 15 verbunden, der der Prüfung unterzogen werden soll.

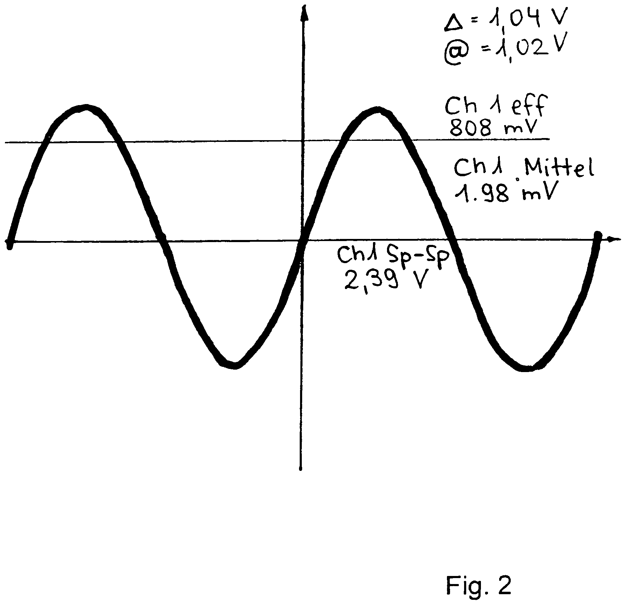

Der Nachteil in der Applikation statischer Frequenzumrichter 2 ist, dass sie prinzipbedingt eine Pulsweiten modulierte, rechteckförmige Ausgangsspannung mit großem Klirrfaktor erzeugen, die in dieser Form zunächst nicht zur Prüfung von Leistungstransformatoren geeignet ist. Wie in Figur 1 dargestellt, wird hierzu ein entsprechender Sinusfilter 6 verwendet. Das Ergebnis der Verwendung dieses Sinusfilters 6 ist in Figur 2 dargestellt. Durch die Verwendung des Sinusfilters 6 ist es möglich, sinusförmige Au-βenleiterspannungen mit einem Klirrfaktor < 5 % zu generieren.

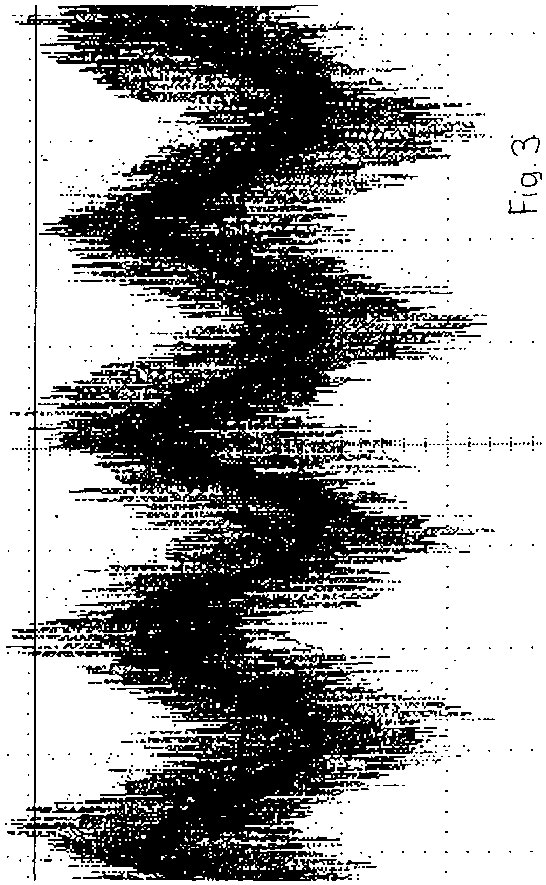

Figur 3 zeigt dennoch Störungen, die trotz der Anwendung des Sinusfilters 6 weiterhin auftreten. Trotz des Sinusfilters 6 lassen sich pulsfrequente Sprünge der Leiter-Erde-Spannung am Wechselrichterausgang nicht unterdrücken (asymmetrische Störungen). Die asymmetrischen Störungen werden somit weit aus dem statischen Frequenzumrichter 2 in den zu prüfenden Transformator 15 geleitet und führen so zu erheblichen Störungen in der Teilentladungsmessung. Es bedarf somit weiterer Maßnahmen, damit durch diese auftretenden asymmetrischen Störungen auch trotzdem Teilentladungsmessungen möglich werden.

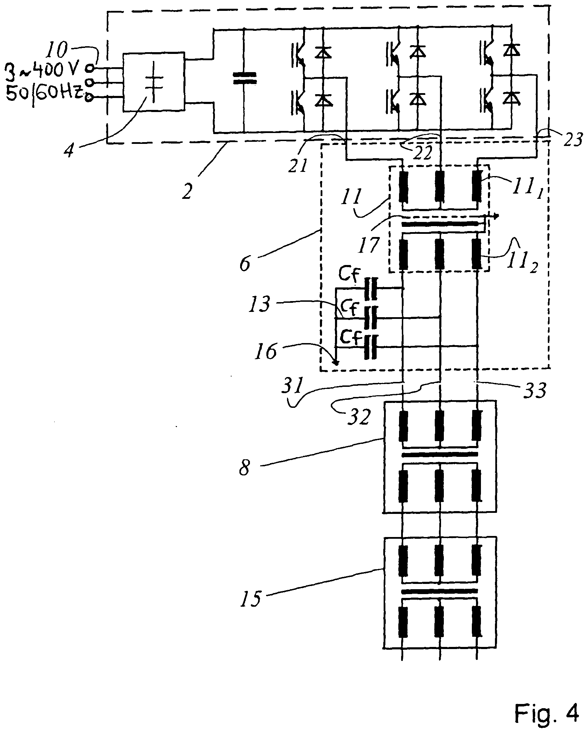

Der nachstehenden Beschreibung der Figur 4 sei vorausgeschickt, dass hier für Merkmale, die mit den Merkmalen der Figur 1 identisch sind, gleiche Bezugszeichen verwendet werden. Durch die erfindungsgemäße Umgestaltung der Filtereinrichtung 6 soll es möglich sein, sowohl die symmetrische Ausgangsspannung des Frequenzumrichters 2 zu filtern, als auch die asymmetrischen Störungen zu unterdrücken. Damit soll es möglich sein, Teilentladungsmessungen am zu prüfenden Transformator 15 durchführen zu können.

Gemäß der Erfindung umfasst die Filtereinrichtung 6 anstatt des bisherigen Sinusfilters einen Filtertransformator 11. Der Filtertransformator 11 ist mit dem ersten Ausgang 21, dem zweiten Ausgang 22 und dem dritten Ausgang 23 des Frequenzumrichters 2 verbunden. Der Filtertransformator 11 umfasst eine Primärseite 11, und eine Sekundärseite 11₂. Der Filtertransformator 11 stellt die benötigte Induktivität einerseits durch seine eigene Streuinduktivität oder andererseits durch integrierte Längsinduktivitäten bereit. Die Sekundärseite 11₂ des Filtertransformators 11 ist mit Filterkondensatoren verbunden, die in einer Stemschaltung 13 angeordnet sind. Der durch die Stemschaltung 13 entstehende Sternpunkt ist mit der Erde 16 verbunden. Der Filtertransformator 11 stellt eine Potenzialtrennung zwischen dem ersten Ausgang 21, dem zweiten Ausgang 22 und dem dritten Ausgang 23 des Frequenzumrichters 2 und den Filterkondensatoren der Sternschaltung 13 her.

Zusätzlich ist zwischen der Primärseite 11₁ und der Sekundärseite 11₂ des Filtertransformators 11 ein elektrostatischer Schirm 17 angeordnet. Der elektrostatische Schirm 17 trägt dabei zusätzlich zur Ableitung der asymmetrischen Störungen bei. Selbstverständlich ist der elektrostatische Schirm 17 ebenfalls geerdet.

Die Filtereinrichtung 6, welche aus dem Filtertransformator 11 und der Stemschaltung 13 der Filterkondensatoren besteht, ist mit einem ersten Ausgang 31, einem zweiten Ausgang 32 und einem dritten Ausgang 33 mit dem Anpasstransformator 8 verbunden. Wie bereits in Figur 1 beschrieben, ist der Anpasstransformator mit dem Transformator 15 verbunden, welcher der Prüfung unterzogen werden soll. Es ist besonders vorteilhaft, wenn der Filtertransformator 11 zusammen mit der Stemschaltung 13 der Filterkondensatoren im Umrichterschaltschrank angeordnet ist. Durch diese räumliche Anordnung kann die Weiterleitung der asymmetrischen Störungen in den zu prüfenden Transformator 15 unterdrückt werden. Somit ist es möglich, die Teilentladungsmessungen durchzuführen, da die asymmetrischen Störungen weggefiltert worden sind.

Es ist von besonderem Vorteil, den Filtertransformator 11 bei der Hochspannungsprüftechnik zu verwenden. Im Spezialfall wird der Filtertransformator 11 bei der Prüfung von Leistungstransformatoren verwendet, um die Teilentladungs-Störemission (asymmetrische Störungen) von statischen Frequenzumrichtern 2 zu unterdrücken. Wie bereits erwähnt, führt ferner die Anordnung des Filtertransformators 11 im Umrichterschrank dazu, dass die asymmetrischen Störungen nicht in das Prüfsystem weitergeleitet werden und dort die Teilentladungsmessung beeinträchtigen.

Die Erfindung wurde in Bezug auf eine Ausführungsform beschrieben. Es ist jedoch denkbar, dass Abwandlungen und Änderungen durchgeführt werden können, ohne dabei den Schutzbereich der nachstehenden Ansprüche zu verlassen.

## Patentansprüche

1. Vorrichtung zur Hochspannungsprüfung von Transformatoren,
mit einem statischen Frequenzumrichter (2), der mehrere Ausgänge (21, 22, 23) umfasst, die mit einer Filtereinrichtung (6) verbunden sind, die ebenfalls mehrere Ausgänge (31, 32, 33) umfasst, die ihrerseits mit einem Anpasstransformator (8) verbunden sind, der seinerseits mit dem zu prüfenden Transformator verbindbar ist,
**dadurch gekennzeichnet,**
**dass** die Filtereinrichtung (6) einen Filtertransformator (11) aufweist,
**dass** zwischen einer Primärseite (11₁) und einer Sekundärseite (11₂) des Filtertransformators (11) ein geerdeter elektrostatischer Schirm (17) vorgesehen ist, dass an jedem Ausgang der Sekundärseite (11₂) des Filtertransformators (11) ein Filterkondensator (C1, C2, C3) abgezweigt ist,
**dass** die Filterkondensatoren (C1, C2, C3) untereinander in einer Sternschaltung mit einem Sternpunkt (13) geschaltet sind
und **dass** der Sternpunkt (13) ebenfalls geerdet ist.

2. Vorrichtung nach Anspruch 1,
**dadurch gekennzeichnet,**
**dass** der statische Frequenzumrichter (2) und der Filtertransformator (11) zusammen mit den Filterkondensatoren (C1, C2, C3) in einem Schaltschrank untergebracht sind, so dass keine asymmetrischen Störungen zu dem der Prüfung unterzogenen Transformator (15) gelangen.

3. Verwendung der Vorrichtung nach den Ansprüchen 1 oder 2,
**dadurch gekennzeichnet,**
**dass** Störungen einer Teilentladungsmessung, die durch einen mit einer Spannungsquelle (4) verbundenen statischen Frequenzumrichter (2) hervorgerufen werden, unterdrückt werden und nicht zu dem der Prüfung unterzogenen Transformator (15) gelangen.

## Claims

1. Device for high-voltage testing of transformers, with a static frequency converter (2) comprising several outputs (21, 22, 23) which are connected with a filter device (6), which similarly comprises several outputs (31, 32, 33) which are in turn connected with a matching transformer (8), which in turn is connectible with the transformer to be checked, **characterised in that** the filter device (6) comprises a filter transformer (11), that an earthed electrostatic screen (17) is provided between a primary side (11₁) and a secondary side (11₂) of the filter transformer (11), that a filter capacitor (C1, C2, C3) is branched off at each output of the secondary side (11₂) of the filter transformer (11), that the filter capacitors (C1, C2, C3) are interconnected in a star circuit with a star point (13) and that the star point (13) is earthed as well.

2. Device according to claim 1, **characterised in that** the static frequency converter (2) and the filter transformer (11) together with the filter capacitors (C1, C2, C3) are accommodated in a switchgear cabinet so that asymmetrical disturbances do not reach the transformer (15) undergoing testing.

3. Use of the device according to claim 1 or 2, **characterised in that** disturbances of a partial discharge measurement, which are produced by a static frequency converter (2) connected with a voltage source (4), are suppressed and do not reach the transformer (15) undergoing testing.

## Revendications

1. Dispositif d'essai à haute tension de transformateur comprenant :
- un redresseur de fréquence, statique (2) ayant plusieurs sorties (21, 22, 23) reliées à une installation de filtre (6) ayant également plusieurs sorties (31, 32, 33) elles-mêmes reliées à un transformateur adaptateur (8) que l'on relie au transformateur à contrôler, dispositif **caractérisé en ce que**
- l'installation de filtre (6) comporte un transformateur de filtre (11),
- entre le primaire (11₁) et le secondaire (11₂) du transformateur de filtre (11), il y a un blindage électrostatique (17) mis à la masse,
- à chaque sortie du secondaire (11₂) du transformateur de filtre (11) il y a en dérivation un condensateur de filtre (C1, C2, C3),
- les condensateurs de filtre (C1, C2, C3) sont branchés entre-eux suivant un montage en étoile avec un point étoile (13), et
- le point étoile (13) est également mis à la masse.

2. Dispositif selon la revendication 1,
**caractérisé en ce que**
le redresseur de fréquence, statique (2) et le transformateur de filtre (11) avec les condensateurs de filtre (C1, C2, C3) sont logés dans une armoire électrique pour qu'aucune perturbation asymétrique n'atteigne le transformateur (15) en cours d'essai.

3. Application du dispositif selon les revendications 1 ou 2,
**caractérisée en ce que**
les perturbations d'une mesure de charge partielle provoquées par un redresseur de fréquence statique (2) relié à une source de tension (4), sont neutralisées et n'arrivent pas au transformateur (15) en cours d'essai.
